# FASCICULE DE BREVET EUROPEEN

(11) **EP 1 079 259 B1**
(45) Date de publication et mention de la délivrance du brevet: **13.11.2013**
(21) Numéro de dépôt: 99116938.4
(22) Date de dépôt: 27.08.1999
(51) Int. Cl.: G02F 1/1333, G02F 1/1345, G04G 17/02, H05K 1/18

(54) **Procédé de réalisation d'un module d'affichage à cellule à cristaux liquides**
Herstellungsverfahren für Anzeigemodul mit Flüssigkristallzelle
Manufacturing method of a display module comprising a liquid crystal cell

(43) Date de publication de la demande: 28.02.2001
(73) Titulaire: The Swatch Group Management Services AG, 2501 Biel (CH)
(72) Inventeur: Pantet, Laurent, 2518 Nods (CH); ALbisetti, Carlo, 2608 Courtelary (CH)
(74) Mandataire: Ravenel, Thierry Gérard Louis

(56) Documents cités:
- EP-A- 0 911 678
- WO-A-94/28459
- JP-A- 10 261 851
- US-A- 4 064 689
- US-A- 4 236 240
- US-A- 5 803 341
- PATENT ABSTRACTS OF JAPAN vol. 017, no. 539 (P-1621), 28 septembre 1993 (1993-09-28) -& JP 05 150254 A (SHARP CORP), 18 juin 1993 (1993-06-18) -& DATABASE WPI Week 199329 Derwent Publications Ltd., London, GB; AN 1993-229305 XP002129023
- PATENT ABSTRACTS OF JAPAN vol. 017, no. 416 (P-1584), 3 août 1993 (1993-08-03) -& JP 05 080316 A (CASIO COMPUT CO LTD), 2 avril 1993 (1993-04-02)
- NOLAN R: "ADVANCED DRIVER PACKAGING IN DISPLAY PRODUCTS" INFORMATION DISPLAY,US,PALISADES INSTITUTE FOR RESEARCH SERVICES. NEW YORK, no. 10, 1 janvier 1996 (1996-01-01), pages 13-15, XP000606823 ISSN: 0362-0972

## Description

L'invention concerne un procédé de réalisation d'un module d'affichage comprenant au moins une cellule à cristaux liquides reliée à un circuit imprimé de commande de l'affichage dont les composants électroniques pour la commande de la cellule et les pistes métalliques de connexion auxdits composants et à ladite cellule sont disposés sur une seule face. L'invention concerne également un module d'affichage pouvant être obtenu selon le procédé, ainsi qu'une montre comprenant un module d'affichage.

Dans des domaines variés, on emploie des affichages à cellules à cristaux liquides, par exemple pour des calculatrices ou pour des dispositifs d'affichage d'informations diverses, qui sont liés à un ou plusieurs circuits imprimés avec des composants électroniques pour la commande des électrodes de la cellule. Parfois, quelques composants électroniques de commande de la cellule se trouvent placés sur la lame de la cellule portant également les plages conductrices liées aux électrodes. Habituellement, la surface définie par la cellule reliée avec le ou les circuits imprimés de commande de l'affichage se trouvant à côté de la cellule est souvent trop importante pour pouvoir être placée dans une boîte d'un appareil de petite dimension où il est nécessaire d'avoir des modules d'affichage compacts.

Les circuits imprimés pour lesdites cellules sont habituellement rigides et le plus souvent leurs plages métalliques de sortie sont connectées électriquement aux plages conductrices respectives de la cellule à cristaux liquides par des barrettes de connexion dénommées "zébra" interposées entre lesdites plages. La pression de contact nécessaire à ce type de connexion induit une certaine tension mécanique entre la cellule, son support et le circuit imprimé, ce qui peut être un désavantage. On n'attache généralement pas une grande importance à l'emplacement du circuit imprimé, qu'il soit au-dessous ou à côté de la cellule à cristaux liquides à connecter. Il n'y a que dans des modes de réalisation modulaire où l'on place habituellement le circuit imprimé en dessous de la cellule avec dans ce cas lesdites barrettes de connexion faisant partie d'éléments d'espacement.

Dans le document US 5,358,412, il est décrit une réalisation modulaire comme mentionné ci-dessus. Le module d'affichage comporte un cadre du module pour enserrer une cellule à cristaux liquides, un élément d'espacement et un circuit imprimé rigide comprenant tous les composants électroniques de commande de ladite cellule. Le circuit imprimé peut être monoface sur lequel une barrette de connexion faisant partie de l'élément d'espacement est comprimée dans le cadre pour connecter d'un côté des plages métalliques de sortie du circuit imprimé et de l'autre côté des plages conductrices reliées aux électrodes de la cellule à cristaux liquides. Le module d'affichage est relié mécaniquement et électriquement à un circuit imprimé flexible pour notamment alimenter en électricité ledit module. La connexion électrique entre ce circuit imprimé flexible et le module se fait au niveau de la surface du circuit imprimé rigide portant des pistes métalliques de sortie du module. Il n'est pas utilisé de colle pour le maintien de la connexion électrique, mais l'extrémité du circuit flexible est pressée entre l'élément d'espacement et les pistes métalliques.de sortie disposées sur le circuit imprimé rigide.

Dans un mode de réalisation, ledit circuit imprimé flexible comporte deux ouvertures venant s'emboîter sur deux piliers du circuit imprimé rigide pour permettre notamment un positionnement précis pour la connexion électrique. On constate que le cadre sert au montage de tous les éléments dudit module, ainsi qu'à la connexion du circuit imprimé flexible audit module.

Etant donné que, dans un mode de réalisation dudit module, toutes les pistes métalliques et tous les composants de commande de la cellule sont disposés sur une seule face du circuit imprimé rigide en direction du dos de la cellule, il subsiste inévitablement un vide entre les composants électroniques et l'arrière de la cellule à cristaux liquides. De même dans le cas où les composants sont placés sur une face opposée du circuit imprimé rigide, il subsiste un vide du fait qu'on utilise une barrette de connexion entre des plages métalliques disposées dans ce cas au dos du circuit imprimé rigide et des plages métalliques respectives de la cellule à cristaux liquides.

L'emploi de circuits flexibles comprenant des pistes métalliques, ainsi que des composants électroniques de commande de cellules à cristaux liquides est aussi connu. Le document US 5,469,412 décrit une montre analogique pour la détection de rayonnements nucléaires. Un circuit imprimé flexible à double face est décrit. Deux languettes portant des plages métalliques sont connectées directement à des plages conductrices respectives de deux cellules d'affichage à cristaux liquides sans l'aide de barrettes de connexion. Ce circuit est positionné sous un cadre comprenant le mouvement de la montre, tandis que les languettes sont courbées de façon à placer les cellules à cristaux liquides sur ce cadre. Une autre partie du circuit imprimé flexible est reliée au détecteur de la montre et courbée pour être placée sous une plaque intermédiaire dans une direction opposée aux cellules.

On peut citer également le document JP 56031684 qui concerne une construction d'une montre à cellule à cristaux liquides. Dans ce document, on peut remarquer que le circuit imprimé flexible monoface est tout d'abord connecté électriquement à ladite cellule sans barrettes de connexion, puis replié en forme d'accordéon sous ladite cellule. Ce type de construction crée une certaine difficulté au montage de l'ensemble dans une boîte de montre de façon à garantir un bon positionnement dudit affichage. Pour ce faire, on doit employer un cadre dans lequel vient se loger la cellule à cristaux liquides pour avoir un affichage bien centré par rapport à la boîte de la montre.

On peut citer également le document de brevet EP 0 911 678, qui décrit un dispositif d'affichage. Ce dispositif d'affichage comprend une cellule à cristaux liquides et un circuit imprimé portant sur une seule face au moins un circuit intégré de commande de la cellule. La face sans composants du circuit imprimé est disposée en regard du dos de la cellule. Une portion d'extrémité du circuit imprimé est repliée à 180° et fixée sur un élément d'espace en silicium. L'extrémité du circuit imprimé fixée sur l'élément d'espace porte une série de pistes métalliques reliant le circuit intégré. Les pistes métalliques sont connectées à des plages correspondantes de la cellule à cristaux liquides par une opération de thermo-compression avec interposition d'une colle conductrice. Le dispositif d'affichage ainsi conçu ne comprend aucun moyen pour bien positionner l'affichage de la cellule lors d'un montage dans une boîte d'un appareil, ce qui constitue un inconvénient.

La présente invention vise à obvier aux inconvénients des modules d'affichage décrits ci-devant. Elle propose de réaliser un module d'affichage compact et à faible épaisseur, agencé de façon qu'on puisse monter facilement et précisément ce module dans une boîte d'un appareil afin que l'affichage soit dans une position déterminée. Ledit module peut être monté notamment dans une boîte d'une montre-bracelet.

Une solution de réalisation dudit module consiste à placer le circuit imprimé du côté du dos de la cellule, à le positionner pour que des moyens d'assemblage du module réalisés sur le circuit imprimé définissent, par rapport à des moyens de repérage de l'affichage disposés sur la cellule, l'emplacement de l'affichage de la cellule, et à fixer la face sans composants du circuit imprimé au dos de la cellule selon la partie caractérisante de la revendication 1.

Une autre solution de réalisation dudit module consiste à placer le circuit imprimé du côté du dos de la cellule, à fixer la face sans composants du circuit imprimé au dos de la cellule, et à réaliser des moyens d'assemblage du module sur le circuit imprimé, positionnés par rapport à des moyens de repérage de l'affichage disposés sur la cellule, pour qu'ils définissent l'emplacement de l'affichage de la cellule selon la partie caractérisante de la revendication 2.

Un des avantages du module obtenu par le procédé, objet de l'invention, est que l'épaisseur de la cellule avec le circuit imprimé monoface, dont la face sans composants est fixée directement au dos de ladite cellule pour le rendre compact, est réduite au minimum de façon à pouvoir être monté, par exemple, dans une montre digitale de faible épaisseur. Il est bien clair que cette épaisseur est dépendante en grande partie de celle de ladite cellule qui est un composant obtenu sur le marché et dont l'épaisseur avoisine 1 mm. Il est envisageable dans un avenir proche d'obtenir de telles cellules d'une épaisseur inférieure à 1 mm.

Un autre avantage du module objet de l'invention est que, du fait que le circuit imprimé a tous les composants électroniques et les pistes métalliques sur une seule surface dudit circuit imprimé, les coûts de fabrication sont réduits au minimum en évitant la création de trous métallisés à travers le circuit imprimé pour établir une liaison électrique des pistes métalliques et des composants qui seraient disposés sur les deux faces. Le montage des composants électroniques sur le circuit imprimé s'en trouve également facilité. De plus, l'arrangement des pistes métalliques est réalisé de façon à ce que lesdites pistes ne se croisent pas sur tout le circuit imprimé. Il faut donc que les bornes de sortie du circuit intégré de commande de la cellule soient en accord avec les bornes respectives à contacter de la cellule pour que les pistes métalliques partant des bornes de sortie du circuit intégré ne se croisent pas jusqu'à la connexion à la cellule.

Etant donné que la connexion électrique du circuit imprimé avec la cellule est réalisée sans éléments intermédiaires, notamment sans barrettes de connexion, on peut prévoir de diminuer l'écartement entre les plages ou bornes métalliques de connexion du circuit imprimé tout comme entre les plages conductrices de la cellule. L'écartement, c'est-à-dire le pas qui est la largeur additionnée d'une piste et d'un espace, pourra donc être inférieur à 0.5 mm, et même inférieur à 0.3 mm, mais cela dépend de ce qui est fourni actuellement sur le marché comme cellules à cristaux liquides. Avec cet écartement réduit, on peut positionner précisément la languette du circuit imprimé portant les plages métalliques de connexion à la cellule au-dessus des plages conductrices respectives de la cellule et de connecter lesdites plages électriquement à l'aide d'une colle conductrice anisotrope qui ne devient conductrice que lorsqu'on la comprime et en appliquant de la chaleur.

Le procédé de réalisation d'un module d'affichage, le module obtenu selon le procédé, ainsi que la montre comprenant un tel module seront expliqués ci-dessous plus en détails par des formes d'exécution non limitatives représentées à l'aide des dessins sur lesquels :
Les figures 1a et 1b représentent le module d'affichage vu de côté et de dessus après l'étape de connexion électrique entre la cellule et le circuit imprimé,
les figures 2a et 2b représentent le module en vue de dessus et de dessous en perspective axonométrique lors de l'étape de placement et de positionnement du circuit imprimé du côté du dos de la cellule,
les figures 3a et 3b représentent le module d'affichage vu de côté et de dessus dans l'état où le circuit imprimé est fixé dans un état positionné au dos de la cellule,
les figures 4a et 4b représentent deux perspectives axonométriques du module d'affichage avant et après son montage dans la boîte d'une montre,
la figure 5 représente une vue en coupe verticale partielle suivant la ligne V-V de la figure 4b de la montre avec le module muni d'une borne de connexion sur le circuit imprimé pour le contact électrique d'une lamelle de commande, et
la figure 6 représente une coupe verticale de la montre avec son module d'affichage monté.

La description suivante est relative à la réalisation d'un module d'affichage pour une montre-bracelet digitale, mais l'utilisation d'un tel module ne se limite bien entendu pas à l'horlogerie; il pourrait être utilisé également dans d'autres domaines où il est nécessaire de rendre ledit module compact, à faible épaisseur et facile à monter précisément dans une boîte d'un appareil grâce à des moyens d'assemblage sur le circuit imprimé, tout en garantissant un bon positionnement de l'affichage.

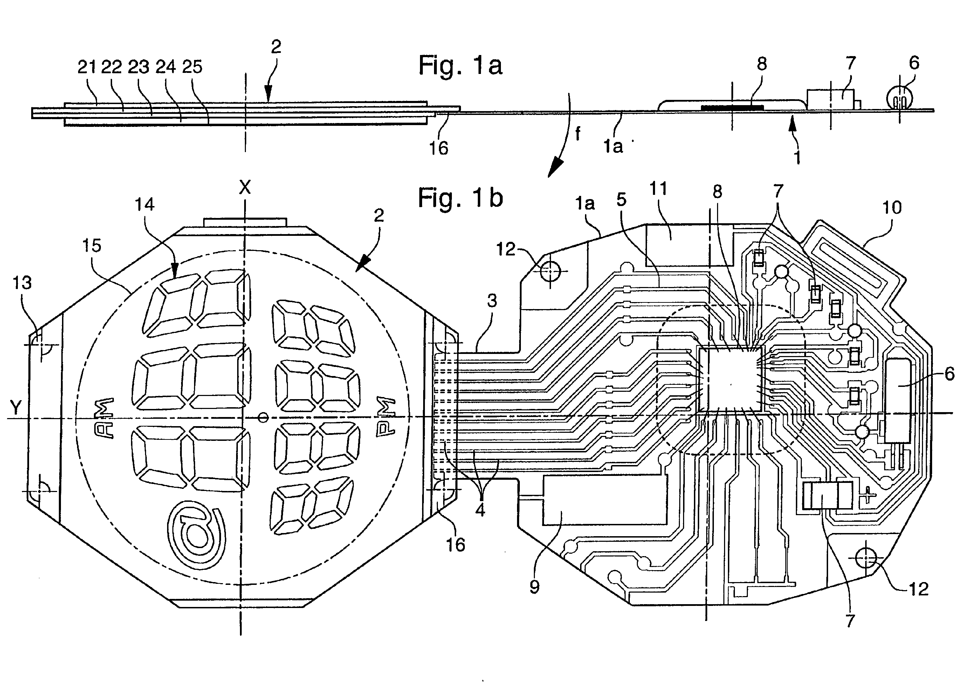

Comme on peut le remarquer sur les figures 1 à 3, le module d'affichage comporte un circuit imprimé flexible 1 ayant un substrat 1a en polyimide ou en polyester d'épaisseur inférieure ou égale à 150 µm, de préférence de 75 µm, et au moins une cellule à cristaux liquides 2.

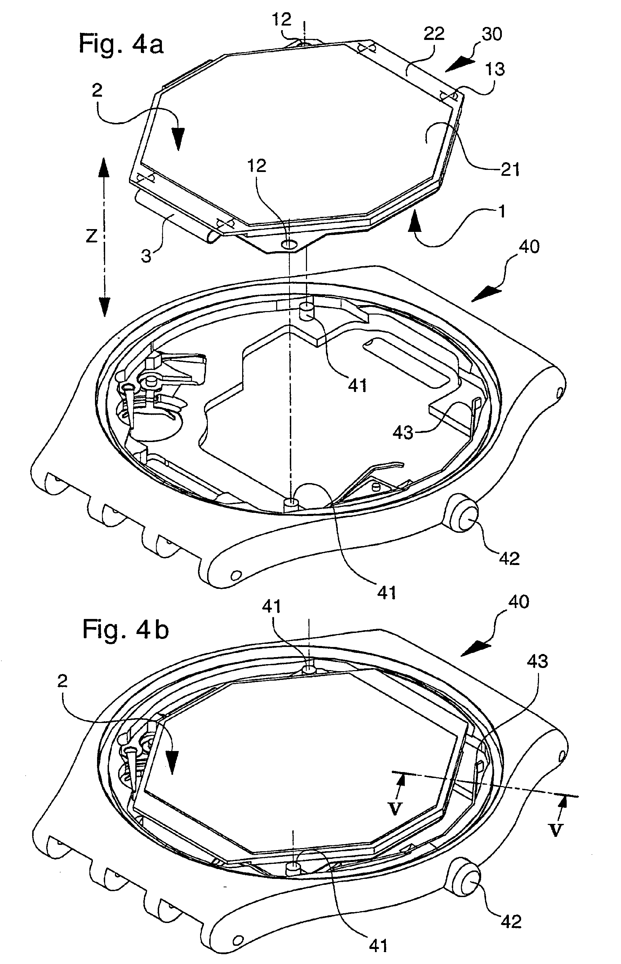

Le circuit imprimé flexible 1 comportent sur une seule face des pistes métalliques 5 reliant la cellule à cristaux liquides 2 et les composants électroniques, à savoir un résonateur à quartz 6, des résistances et capacités 7 et un circuit intégré de commande de l'affichage 8. A une des extrémités, il comprend une languette 3 portant des plages métalliques 4 de connexion à la cellule à cristaux liquides 2. Ces plages métalliques 4 sont régulièrement espacées ou non et placées en parallèle les unes à côté des autres en fonction des plages conductrices disposées de la même manière avec un espacement équivalent sous un prolongement 16 de la première lame 22 de la cellule à cristaux liquides 2. Une borne métallique 9 est prévue pour le contact d'alimentation provenant du pôle négatif d'une batterie. Une borne métallique 11 permet le contact d'une lamelle de connexion de la platine métallique du fond de la boîte de montre, cette platine étant reliée au pôle positif de la batterie. Il est également prévu une borne métallique 10 qui peut être repliée et collée contre un bord de la cellule pour servir au contact d'une lamelle de commande 43 actionnée par un bouton-poussoir 42, visibles en figures 4a et 4b, afin de faire afficher sur la cellule les diverses informations horaires et de dates, ainsi que pour le réglage des heures et dates. Il est à noter qu'il n'est pas indispensable de replier cette partie du circuit imprimé portant la borne 10, car la lamelle 43 pourrait très bien glisser sous le circuit imprimé et venir contacter la borne 10 par dessous.

Le circuit intégré 8 est réalisé de façon à ce que les pistes métalliques 5 reliant les sorties du circuit intégré 8 avec les plages conductrices à connecter et les composants discrets 6 et 7 montés sur le circuit imprimé 2 ne se croisent pas.

Du fait que la cellule à cristaux liquides 2 provient d'une plaque qui comprend plusieurs cellules à séparer les unes des autres, cela ne permet pas de situer précisément où se trouve l'emplacement de l'affichage 14, c'est pourquoi des cibles 13, comme moyens de repérage et d'alignement optique, sont prévues pour situer précisément son emplacement. Le circuit imprimé comprend également des moyens d'assemblage du module positionnés en rapport aux cibles 13 de la cellule que ce soit de manière optique ou mécanique en employant les moyens d'assemblage pour le déplacement du circuit imprimé. Ce positionnement du circuit imprimé par rapport à la cellule peut bien entendu être opéré également avec d'autres moyens de repérage ou d'autres cibles placés sur ledit circuit visibles par exemple par transparence. Dans ce cas, les cibles ou les moyens de repérage sont alignés optiquement de manière parfaitement précise.

Les moyens d'assemblage finals sont deux trous 12 disposés sur deux oreilles 17 placées aux extrémités d'une diagonale du circuit imprimé. Une fois le module terminé, les deux trous 12 permettent de monter précisément latéralement ledit module sur deux tétons 41 de la boîte de montre, visibles en figures 4a et 4b afin d'avoir un affichage de la cellule dans une position parfaitement déterminée et précise.

La forme des trous 12 n'est pas forcément circulaire. On peut prévoir un trou de forme ovale et l'autre de forme circulaire.

La cellule 2 à cristaux liquides, qui peut être du type nématique (TN), comporte un film polariseur 21 fixé sur la première lame 22. La deuxième lame 23 est fixée sous la première lame 22. Les deux lames sont configurées pour enfermer les cristaux liquides entre elles. Une dernière lame servant de polariseur/réflecteur 24 est fixée sous la deuxième lame 23 pour permettre la polarisation et la réflexion de la lumière entrant depuis le film polariseur 21 côté affichage 14. Les plages conductrices de la cellule, disposées sur un prolongement 16 de la première lame 22, terminent des électrodes transparentes de commande de l'affichage 14 qui sont arrangées en lignes et en colonnes sur la première lame 22 et la seconde lame 23, non visibles sur les figures. L'épaisseur d'une telle cellule est inférieure à 1.1 mm, chaque lame étant d'épaisseur inférieure ou égale à 0.3 mm et le film polariseur étant d'épaisseur inférieure à 0.2 mm.

La forme de la cellule est par exemple octogonale de façon à pouvoir être montée dans une boîte de montre-bracelet circulaire avec une partie visible de l'extérieur 15 de diamètre avoisinant 20 mm, montrée en traits interrompus sur les figures 1 à 3, sous le verre de montre, mais il est bien clair que la forme de la cellule pourrait également être rectangulaire pour être montée dans une boîte rectangulaire.

Plusieurs étapes du procédé vont être décrites en référence aux figures 1 à 3 pour la construction du module d'affichage.

Le circuit imprimé flexible 1 est fourni, selon des techniques courantes, d'une bobine, non représentée sur les figures, sur laquelle est enroulée une bande comprenant plusieurs circuits imprimés disposés les uns à la suite des autres sur ladite bande, dont uniquement les pistes métalliques 5, notamment en cuivre, sur une seule face sont réalisées. Il est important de tout concevoir sur une seule face, car on évite le besoin de réaliser des trous métallisés pour créer des passages de connexion électrique d'une face à l'autre, par mesure d'économie et de facilité de montage des composants électroniques.

En tirant sur ladite bande, on vient placer un ou plusieurs circuits imprimés 1 en position pour pouvoir monter les composants électroniques 6, 7 et 8 sur chaque circuit imprimé monoface avant ou après avoir découpé de la bande la série de circuits imprimés identiques. De ce fait, les languettes 3 des circuits imprimés 1 peuvent être disposées perpendiculairement à l'axe longitudinal de la bande, c'est-à-dire par rapport à un des bords de la bande. Ce montage peut être automatisé comme il est habituel à la connaissance d'un homme du métier dans ce domaine.

Bien que plusieurs circuits imprimés peuvent être tirés en même temps de ladite bande, la description sera faite par simplification uniquement dans le cas où un seul circuit imprimé est tiré de ladite bande avec les composants électroniques montés avant ou après l'avoir découpé de ladite bande sans pour autant se limiter à ce cas particulier.

Une fois tous les composants électroniques 6 et 7 montés et le circuit intégré 8 de commande de l'affichage monté et encapsulé sur le circuit imprimé 2, on procède à la connexion des plages métalliques 4 de la languette 3 du circuit imprimé aux plages correspondantes de la cellule 2 à cristaux liquides. La face du circuit imprimé 1 sans composants est tout d'abord maintenue sur une surface plane pour cette étape de procédé.

Une bande de colle conductrice anisotrope est posée soit aux extrémités des plages métalliques 4 du circuit imprimé, soit sur les plages conductrices de la cellule 2 avant cette connexion. Le prolongement 16 de la première lame 22 de la cellule 2 portant les plages conductrices est amené au-dessus des plages métalliques 4 à l'extrémité de la languette 3 avec interposition de la bande de colle anisotrope, les plages métalliques et conductrices se faisant face.

On peut utiliser par exemple une caméra placée au-dessus de la cellule pour l'alignement et positionnement desdites plages en regard respectivement les unes sur les autres par transparence du prolongement 16 de la lame 22. Des cibles 13 au nombre de quatre, prévues en tant que moyens de repère sur la lame 22, peuvent servir également à la caméra pour positionner ladite languette, mais étant donné la transparence du bord de la première lame 22 de la cellule et la vision des plages conductrices sous le verre, les cibles 13 ne sont pas jugées nécessaires à cette étape de procédé.

Pour les connexions mécanique et électrique de la cellule et du circuit imprimé, on presse le prolongement 16 de la lame 22 contre la languette 3 en chauffant pour le collage, par exemple à une température avoisinant les 180°C. Ladite colle anisotrope est constituée d'une résine thermodurcissable avec de la poudre conductrice incorporée. Elle ne devient conductrice que lorsqu'elle est comprimée. Etant donné que les plages métalliques et conductrices sont des parties saillantes sur le circuit imprimé et sur le prolongement avec des espaces vides entres chaque plage, la colle n'est comprimée qu'entre chaque plage métallique 4 connectée à la plage conductrice respective de la cellule 2. Par contre dans les espaces vides entre les plages conductrices et les espaces vides entre les plages métalliques, la colle restera isolante. La connexion de chaque plage métallique avec chaque plage conductrice se fait sur une distance allant de 1 mm à 2 mm.

L'espacement centre à centre des plages métalliques se trouvant sur la languette 3 est équivalent à l'espacement des plages conductrices à connecter de la cellule 2. Auparavant avec l'emploi de barrettes de connexion l'espacement était de dimension avoisinant 0.5 mm. Avec cette connexion sans lesdites barrettes, il est possible de réduire cet espacement en-dessous de 0.3 mm sans créer de court-circuit entre lesdites plages. La largeur d'une plage métallique est de l'ordre de 0.15 mm et l'espace séparant deux plages voisines est de l'ordre de 0.15 mm. Les espaces et les plages ne sont pas forcément d'égale grandeur.

Le résultat de cette étape du procédé est montré aux figures 1a et 1b. La flèche f indique le sens du pliage à 180° subséquent du circuit imprimé 1 qui doit être placé au dos de la cellule 2.

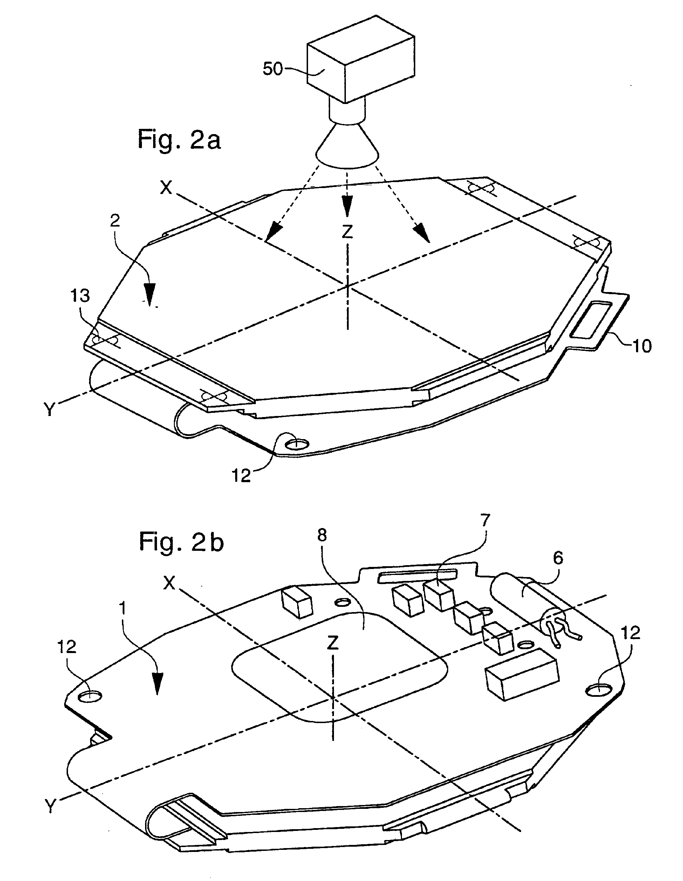

Dans l'étape suivante du procédé, visible aux figures 2a et 2b, un dispositif de vision artificielle 50 est utilisé pour le positionnement du circuit imprimé par rapport à la cellule. Une image de la cellule 2 avec ces cibles 13, définissant l'emplacement de l'affichage 14 (figure 1b), est mémorisée avant le pliage du circuit imprimé au-dessus de la cellule. Pour cela, la cellule 2 côté affichage est maintenue sur une surface plane dans un posage. Après quoi, le circuit imprimé flexible 1, maintenu par un outil à ventouse, est plié de façon à se trouver parallèlement dans une position écartée au-dessus du dos de la cellule, la face sans composants étant en regard du dos de ladite cellule. La superficie du circuit imprimé est légèrement plus grande que celle de la cellule, ce qui fait que lors du positionnement en X et Y, il recouvre pratiquement complètement ladite cellule.

Le circuit imprimé, comprenant deux trous 12 comme moyens d'assemblage du module, est déplacé selon les axes X et Y parallèlement au dos de la cellule de façon à le positionner par rapport aux cibles 13 mémorisées définissant l'emplacement de l'affichage 14 de la cellule à cristaux liquides 2. Pour le positionnement du circuit imprimé par rapport aux cibles 13, on utilise comme repère soit les moyens d'assemblage du module, qui sont les deux trous 12 pratiqués sur deux oreilles 17, soit l'image mémorisée du circuit imprimé, sachant que d'après cette image la position des trous 12 est bien définie par rapport à l'emplacement de l'affichage de la cellule.

Normalement un déplacement selon Y peut suffire dans cette étape de procédé si le positionnement en X a été déjà opéré dans l'étape de connexion de la languette 3 sous le prolongement 16 de la première lame 22 de la cellule 2.

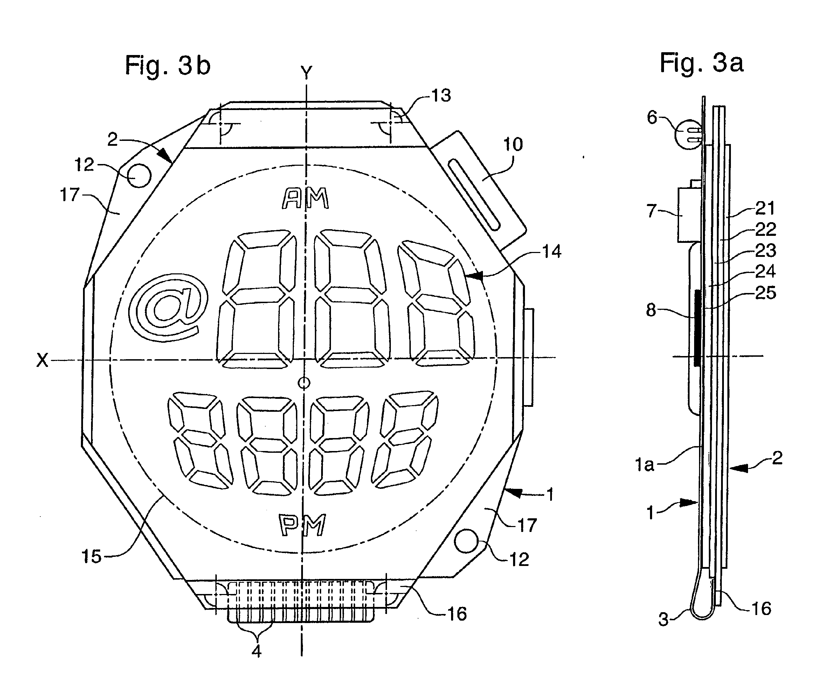

Une fois le positionnement en X et Y du circuit imprimé par rapport à la cellule terminé, il s'agit de déplacer en Z le circuit imprimé flexible vers le dos de la cellule où une bande de colle double face 25 (figure 1a), d'épaisseur proche de 50 µm, a été posée au préalable en recouvrant tout le dos 24 de ladite cellule. Dès que la face sans composants du circuit imprimé est plaquée contre la bande de colle, le module d'affichage est terminé, comme représenté aux figures 3a et 3b. Les deux oreilles 17 ne sont pas collées et restent libres. En vue de dessus dudit module à la figure 3b, les deux oreilles 17 du circuit imprimé avec les deux trous 12 pour le montage du module dans la boîte de montre dépasse de la périphérie de la cellule.

Dans une forme de réalisation quelque peu différente, on peut réaliser les trous 12 du circuit imprimé 1 à la fin du procédé de fabrication dudit module au lieu qu'ils soient déjà présents initialement. Dans ce cas, on colle la face sans composants du circuit imprimé flexible sous la cellule, laissant deux parties en forme d'oreilles 17 du circuit imprimé accessibles après collage. Ensuite de quoi, un outil vient percer chacun des deux trous 12 sur les oreilles 17 en fonction de l'emplacement de l'affichage 14 avec l'aide des cibles 13 mémorisées par le dispositif de vision artificielle 50.

Il est possible d'utiliser toute forme de moyens d'assemblage différente des trous discutés ci-dessus, par exemple deux tétons fixés ou réalisés sur le circuit imprimé pour le montage du module dans une boîte d'un appareil ayant des moyens complémentaires de réception des tétons du circuit imprimé, mais cela complique la fabrication dudit module.

Il est encore concevable de placer tout d'abord le circuit imprimé 1 parallèlement au dos de la cellule 2, la face sans composants dudit circuit imprimé étant en regard du dos de la cellule, de positionner en X et Y le circuit imprimé en fonction de l'image de la cellule, puis déplacer le circuit imprimé en Z pour venir le coller au dos de la cellule. Les moyens d'assemblage du module sont réalisés avant ou après la fixation des deux éléments.

Par la suite, on vient connecter la languette 3 du circuit imprimé sous le prolongement 16 de la première lame 22. Pour réussir une telle opération une fois le circuit imprimé déjà collé au dos de la cellule, la languette peut être réalisée avec une ouverture centrale, les pistes métalliques 5 se terminant par les plages métalliques 4 de connexion devant passer autour de l'ouverture. Une bande de colle conductrice anisotrope est placée soit sur l'extrémité des plages métalliques de la languette 3, soit sur les plages conductrices de la cellule. L'ouverture de la languette est prévue pour qu'on puisse avec un outil presser et chauffer la languette 3 une fois positionnée pour sa connexion électrique et mécanique aux plages conductrices de la cellule sous ledit prolongement 16.

Les moyens de repérage utilisés pour le positionnement du circuit imprimé 1 avec la cellule 2 pourraient être constitués, au lieu des cibles 13, de l'affichage lui-même si la cellule était alimentée en électricité.

Dans le cas où l'on souhaite utiliser deux cellules à cristaux liquides 2 montées l'une sur l'autre, les étapes du procédé sont équivalentes à ce qui vient d'être décrit. Les deux séries de plages conductrices sous les prolongements 16 de chacune des cellules sont décalées selon l'axe X de façon à ne pas se superposer en vue de dessus.

Le circuit imprimé 1 comprend deux languettes 3 disposées l'une à côté de l'autre portant chacune les plages métalliques 4 de connexion aux plages conductrices de la cellule correspondante. Une bande de colle est posée soit sur les prolongements 16 de chacune des cellules, soit sur les languettes 3. Dès que les languettes 3 sont positionnées sur les plages conductrices de chacune des cellules, on les presse et chauffe pour leur fixation, comme expliqué plus haut.

Une fois cette étape terminée, le circuit imprimé au niveau des languettes est plié à 180° de façon à se trouver parallèlement à une certaine distance du dos de la deuxième cellule, et positionné en X et Y, avant d'être déplacé selon l'axe Z pour venir se coller sur une bande collante à double face 25 placée sous la deuxième cellule. La languette 3 connectant la première cellule décrit un rayon de courbure plus important que la languette 3 connectant la deuxième cellule.

Bien entendu lors de la réalisation d'un module à deux cellules, la fixation des languettes 3 sous les prolongements 16 des premières lames 22 des cellules peut être exécutée après avoir positionné et fixé la face sans composants du circuits imprimés au dos de la deuxième cellule.

En figures 4a et 4b, il est représenté le montage du module d'affichage 30 dans une boîte de montre 40. Les deux trous 12 pratiqués sur le circuit imprimé permettent de maintenir et positionner ledit module 30 dans son propre plan facilement et précisément dans ladite boîte 40 sur deux tétons 41, venus du moulage avec la boîte en plastique. Le module une fois placé sur les deux tétons permet d'avoir un affichage positionné latéralement dans la boîte de montre avec une précision inférieure à 100 µm. Une fois introduit dans la boîte, le module 30 est scellé à la boîte en déformant par chauffage, ou par ultrasons ou par un autre moyen de déformation, la partie sommitale des tétons 41.

La cellule à cristaux liquides peut reposer sur quatre appuis de la boîte une fois que le module est posé sur les tétons 41. Mais il peut être prévu également de venir fixer ledit module sur le fond de la boîte sans l'utilisation d'appuis de la cellule, afin de gagner encore sur l'épaisseur de la montre de l'ordre de 3.9 mm. Il faut savoir que l'épaisseur du module, de l'ordre de 2.7 mm, est dépendante de l'épaisseur de la cellule 2 et également de celle du résonateur à quartz 6 et des composants discrets 7.

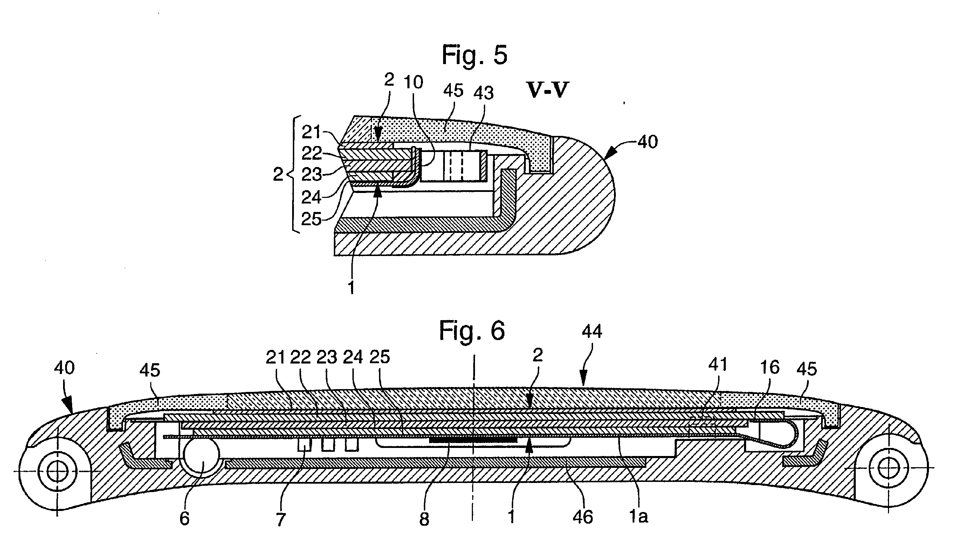

La figure 5 montre uniquement une partie du circuit imprimé flexible qui est pliée et collée contre un bord de la cellule, ladite partie portant une borne métallique 10 pour le contact d'une lamelle conductrice flexible de commande 43 poussée par un bouton-poussoir 42, visibles aux figures 4a et 4b. En pressant sur le bouton-poussoir 42, on peut sélectionner différents modes d'affichage de la cellule, et régler les heures et dates de la montre.

La figure 6 montre une coupe verticale du montage terminé de la montre avec son module d'affichage 30. Le verre 44 de la montre comprend un anneau périphérique 45 opaque pour cacher les bords de la cellule et les éléments du fond de la boîte 40, afin que ne reste visible que la partie 15 (figure 1b) de l'affichage. La boîte est moulée en plastique avec une platine métallique de fond 46 reliée au pôle positif de la batterie.

L'invention qui vient d'être décrite ne se limite bien entendu pas à la réalisation du module d'affichage d'une montre-bracelet, mais couvre tout module d'affichage, à la portée d'un homme du métier, ayant des moyens d'assemblage, réalisés sur le circuit imprimé fixé au dos de la cellule et positionné par rapport à l'emplacement de l'affichage, pour faciliter le montage sur des moyens complémentaires réalisés dans un dispositif le recevant.

## Revendications

1. Procédé de fabrication d'un module d'affichage comprenant au moins une cellule à cristaux liquides (2) reliée à un circuit imprimé (1) de commande de l'affichage, ledit circuit imprimé (1) ayant, disposés sur une seule face, des composants électroniques (6, 7, 8) pour la commande de la cellule (2) et des pistes métalliques de connexion (5) auxdits composants et à ladite cellule (2), **caractérisé en ce que** le procédé comprend les étapes de :
- placer le circuit imprimé (1) du côté du dos de la cellule (2), la face sans composants dudit circuit imprimé (1) étant en regard du dos de ladite cellule (2),
- positionner le circuit imprimé (1) par rapport à la cellule (2), ledit circuit imprimé (1) comportant des moyens d'assemblage du module (12) pour le montage du module dans une boîte d'un appareil, lesdits moyens d'assemblage étant prévus pour que, lors du positionnement du circuit imprimé (1) par rapport à des moyens de repérage de l'affichage (13) disposés sur la cellule (2), l'affichage de la cellule (2) soit positionné par rapport aux moyens d'assemblage, et
- fixer une partie de la face sans composants du circuit imprimé (1) directement au dos de ladite cellule (2).

2. Procédé de fabrication d'un module d'affichage comprenant au moins une cellule à cristaux liquides (2) reliée à un circuit imprimé (1) de commande de l'affichage, ledit circuit imprimé (1) ayant, disposés sur une seule face, des composants électroniques (6, 7, 8) pour la commande de la cellule (2) et des pistes métalliques de connexion (5) auxdits composants et à ladite cellule (2), **caractérisé en ce que** le procédé comprend les étapes de :
- placer le circuit imprimé (1) du côté du dos de la cellule (2), la face sans composants dudit circuit imprimé (1) étant en regard du dos de ladite cellule (2),
- fixer une partie de la face sans composants du circuit imprimé (1) directement au dos de ladite cellule (2), et
- réaliser des moyens d'assemblage du module (12) sur le circuit imprimé (1), pour le montage du module dans une boîte d'un appareil, lesdits moyens d'assemblage étant positionnés par rapport à des moyens de repérage (13) disposés sur la cellule (2), pour que l'affichage de la cellule (2) soit positionné par rapport aux moyens d'assemblage.

3. Procédé selon l'une des revendications 1 et 2, **caractérisé en ce que** le circuit imprimé (1) est flexible, **en ce que**, dans une étape préliminaire, on connecte des plages métalliques (4) du circuit imprimé (1) disposées sur une extrémité en forme de languette (3) dudit circuit imprimé (1) sur des plages conductrices correspondantes de la cellule (2) disposées sur une des lames (22) de ladite cellule (2), et **en ce que** le circuit imprimé (1), au niveau de la languette (3), est plié à 180° pour être placé du côté du dos de la cellule (2).

4. Procédé selon l'une des revendications 1 et 2, **caractérisé en ce que** le circuit imprimé (1) est flexible, **en ce que**, dans une étape finale, on plie à 180° et fixe une extrémité en forme de languette (3) pour venir connecter des plages métalliques (4) du circuit imprimé (1) disposées sur la languette (3) sur des plages conductrices correspondantes de la cellule (2) disposées sur une des lames (22) de ladite cellule (2).

5. Procédé selon l'une des revendications 3 et 4, **caractérisé en ce que** le module est composé de deux cellules à cristaux liquides (2) dont la première cellule est fixée au-dessus de la deuxième cellule, ledit circuit imprimé (1) étant fixé au dos de la deuxième cellule (2), et **en ce que** le circuit imprimé (1) comprend deux languettes (3) placées l'une à côté de l'autre sur une même extrémité, portant chacune une série de plages métalliques (4) pour la connexion électrique et mécanique du circuit imprimé (1) aux plages conductrices des cellules (2) respectives, les deux séries de plages conductrices ne se recouvrant pas en vue de dessus.

6. Procédé selon l'une des revendications 3 à 5, **caractérisé en ce qu'**on effectue la connexion des plages métalliques (4) du circuit imprimé (1) sur les plages conductrices respectives de la ou des cellules à cristaux liquides (2) en appliquant une bande de colle conductrice anisotrope sur les plages conductrices ou sur les plages métalliques (4), en plaçant la ou les languettes en regard d'un prolongement (16) de lame respective portant lesdites plages conductrices de façon à aligner en superposition chaque plage métallique (4) avec chaque plage conductrice correspondante, et en comprimant et chauffant la ou les languettes (3) contre la face de la lame (22) respective pour établir la connexion électrique entre lesdites plages métalliques (4) et conductrices, ladite colle étant conductrice uniquement entre les plages métalliques (4) comprimées contre les plages conductrices respectives, la colle restant isolante dans les espaces vides entre les plages métalliques (4) et dans les espaces vides entre les plages conductrices.

7. Procédé selon l'une des revendications 1 et 2, **caractérisé en ce que** la surface entière du dos de la cellule (2) est fixée sur la face sans composants du circuit imprimé (1).

8. Procédé selon l'une des revendications 1, 2 et 7, **caractérisé en ce que** les moyens d'assemblage du module (12) sont deux trous pratiqués sur deux oreilles (17) du circuit imprimé (1) s'étendant au-delà de la surface du dos de la cellule (2).

9. Procédé selon l'une des revendications 1 et 2, **caractérisé en ce que** le circuit imprimé (1) est fixé au dos de la cellule (2) à l'aide d'une bande collante à double face (25).

10. Procédé selon l'une des revendications 1 et 2, **caractérisé en ce qu'**un bord du circuit imprimé (1) portant une borne de contact métallique (10) est plié à 90° et collé sur la tranche de la cellule.

11. Module d'affichage, notamment pour une montre-bracelet, ledit module comprenant au moins une cellule à cristaux liquides (2) reliée à un circuit imprimé flexible (1) de commande de l'affichage, ledit circuit imprimé (1) ayant, disposés sur une seule face, des composants électroniques (6, 7, 8) pour la commande de la cellule (2) et des pistes métalliques de connexion (5) auxdits composants et à ladite cellule (2), une partie de la face sans composants du circuit imprimé (1) étant fixée et positionnée directement au dos de la cellule (2), une extrémité du circuit imprimé en forme de languette (3) portant une série de plages métalliques de connexion (4) à ladite cellule (2) étant pliée à 180° et raccordée mécaniquement et électriquement sur des plages conductrices respectives de la cellule (2), caractérisé_en ce que le circuit imprimé (1) comprend des moyens d'assemblage (12) du module pour le montage du module dans une boîte d'un appareil, lesdits moyens d'assemblage étant prévus pour que l'affichage de la cellule (2), qui comprend des moyens de repérage de l'affichage (13), soit positionné par rapport aux moyens d'assemblage, et en ce qu'un bord du circuit imprimé flexible (1) portant une borne de contact métallique (10) est dans un état plié et collé sur la tranche de la cellule (2).

12. Module selon la revendication 11, **caractérisé en ce que** les plages métalliques (4) sur la languette (3) et les plages conductrices respectives de la cellule (2) sont connectées à l'aide d'une bande de colle conductrice anisotrope qui n'est conductrice qu'entre les plages métalliques (4) comprimées contre les plages conductrices respectives, la colle restant isolante dans les espaces vides entre les plages métalliques (4) et dans les espaces vides entre les plages conductrices

13. Module selon la revendication 11, **caractérisé en ce qu'**il est constitué de deux cellules à cristaux liquides (2) dont la première cellule est fixée au-dessus de la deuxième cellule, le circuit imprimé flexible (1) étant fixé au dos de la deuxième cellule (2), et **en ce que** le circuit imprimé (1) comprend deux languettes (3) placées l'une à côté de l'autre sur une même extrémité du circuit imprimé (1), portant chacune une série de plages métalliques (4) de connexion électrique et mécanique aux plages conductrices des cellules respectives, les deux séries de plages conductrices ne se recouvrant pas en vue de dessus.

14. Module selon la revendication 11, **caractérisé en ce que** le circuit imprimé (1) est collé sur toute la surface du dos de la cellule (2) qui comprend un polariseur supérieur (21) et trois lames (22, 23, 24) dont la dernière lame, sur laquelle est collée le circuit imprimé, est du type réflecteur/polariseur.

15. Montre comportant un module d'affichage selon l'une des revendications 11 à 14, **caractérisé en ce que** la boîte de montre (40) comprend des moyens d'assemblage complémentaires (41) coopérant avec les moyens d'assemblage du module (12) pour le positionnement latéral dudit module afin que l'affichage de la cellule à cristaux liquides (2) soit dans une position déterminée dans la boîte de montre (40).

16. Montre selon la revendication 15, **caractérisé en ce que** les moyens d'assemblage complémentaires (41) sont deux tétons s'élevant verticalement depuis le fond de la boîte (40) coopérant avec les moyens d'assemblage du module (12) qui comprennent deux trous placés sur deux oreilles (17) s'étendant au-delà de la surface du dos de la cellule (2).

## Patentansprüche

1. Verfahren zur Herstellung eines Anzeigemoduls, welches zumindest eine Flüssigkristallzelle (2) aufweist, die mit einer gedruckten Steuerschaltung (1) der Anzeige verbunden ist, wobei die gedruckte Schaltung auf einer einzigen Seite angeordnete elektronische Komponente (6, 7, 8) zur Steuerung der Zelle (2) sowie metallische Verbindungsbahnen an den Komponenten und an der Zelle (2) aufweist, **gekennzeichnet dadurch, dass** das Verfahren folgende Schritte aufweist:
- Platzieren der gedruckten Schaltung (1) auf der Rückseite der Zelle (2), wobei die komponentenlose Seite der gedruckten Schaltung der Rückseite der Zelle (2) gegenüberliegt,
- Positionieren der gedruckten Schaltung (1) gegenüber der Zelle (2), wobei die gedruckte Schaltung mit Montagemitteln des Moduls (12) ausgestattet ist, um das Modul in einem Gehäuse eines Geräts zu montieren, wobei die Montagemittel dazu vorgesehen sind, anlässlich der Positionierung der gedruckten Schaltung (1) gegenüber auf der Zelle (2) angeordneten Kennzeichnungsmitteln der Anzeige (13), die Anzeige der Zelle (2) gegenüber den Montagemitteln zu positionieren, und
- Fixieren eines Abschnitts der komponentenlosen Seite der gedruckten Schaltung (1) direkt auf der Rückseite der Zelle (2).

2. Verfahren zur Herstellung eines Anzeigemoduls, welches zumindest eine Flüssigkristallzelle (2) aufweist, die mit einer gedruckten Steuerschaltung (1) der Anzeige verbunden ist, wobei die gedruckte Schaltung auf einer einzigen Seite angeordnete elektronische Komponente (6, 7, 8) zur Steuerung der Zelle (2) sowie metallische Verbindungsbahnen an den Komponenten und an der Zelle (2) aufweist, **gekennzeichnet dadurch, dass** das Verfahren folgende Schritte aufweist:
- Platzieren der gedruckten Schaltung (1) auf der Rückseite der Zelle (2), wobei die komponentenlose Seite der gedruckten Schaltung der Rückseite der Zelle (2) gegenüberliegt,
- Fixieren eines Abschnitts der komponentenlosen Seite der gedruckten Schaltung (1) direkt auf der Rückseite der Zelle (2), und
- Verwirklichen der Montagemittel des Moduls (12) auf der gedruckten Schaltung (1), für die Montage des Moduls in einem Gehäuse eines Geräts, wobei die Montagemittel gegenüber den auf der Zelle (2) angeordneten Kennzeichnungsmittel (13) positioniert sind, um die Anzeige der Zelle (2) gegenüber den Montagemitteln zu positionieren.

3. Verfahren nach einem der Ansprüche 1 und 2, **dadurch gekennzeichnet, dass** die gedruckte Schaltung (1) flexibel ist, damit man in einem Vormontageschritt die metallischen Bereiche (4) der gedruckten Schaltung (1), welche an einem Ende in Form einer Zunge (3) der gedruckten Schaltung (1) angeordnet sind, mit den leitenden korrespondierenden Bereichen der Zelle (2) verbindet, die auf einem Blatt (22) der Zelle (2) angeordnet sind, wobei die gedruckte Schaltung (1) auf Höhe der Zunge (3) um 180° gebogen ist, um diese auf Seiten der Rückseite der Zelle (2) zu platzieren.

4. Verfahren nach einem der Ansprüche 1 und 2, **dadurch gekennzeichnet, dass** die gedruckte Schaltung (1) flexibel ist, damit man sie in einem finalen Schritt um 180° biegt und ein in Form einer Zunge (3) ausgebildetes Ende fixiert, um die metallischen Bereiche (4) der gedruckten Schaltung, welche auf der Zunge (3) ausgebildet sind, mit den leitenden korrespondierenden Bereichen der Zelle (2) zu verbinden, welche auf einem Blatt (22) der Zelle (2) angeordnet sind.

5. Verfahren nach einem der Ansprüche 3 und 4, **dadurch gekennzeichnet, dass** das Modul aus zwei Flüssigkristallzellen (2) gebildet ist, von denen die erste Zelle auf der zweiten Zelle fixiert ist, wobei die gedruckte Schaltung (1) auf der Rückseite der zweiten Zelle (2) fixiert ist, wobei die gedruckte Schaltung (1) zwei am selben Ende nebeneinander platzierte Zungen (3) aufweist, von denen jede eine Reihe metallischer Bereiche (4) zur elektrischen und mechanischen Verbindung der gedruckten Schaltung (1) an den entsprechenden leitenden Bereichen der Zelle (2) aufweist, wobei sich die beiden Reihen der leitenden Bereiche nicht überdecken.

6. Verfahren nach einem der Ansprüche 3 bis 5, **dadurch gekennzeichnet, dass** man die Verbindung der metallischen Bereiche (4) der gedruckten Schaltung (1) auf den entsprechenden leitenden Bereichen der Flüssigkristallzelle oder Flüssigkristallzellen (2) durch Vorsehen eines leitenden anisotropen Klebebandes auf den leitenden Bereichen oder auf den metallischen Bereichen (4) vorsieht, in dem man die Zunge oder die Zungen gegenüber einer Verlängerung (16) vom entsprechenden Blatt, welches die leitenden Bereiche aufweist, derart platziert, dass jeder metallische Bereich (4) mit jedem korrespondierenden leitenden Bereich überlagert ist und dass man die Zunge oder die Zungen (3) gegen die entsprechende Seite des Blatts (22) komprimiert und erhitzt, um die elektrische Verbindung zwischen den metallischen (4) und den leitenden Bereichen zu bilden, wobei der Kleber ausschließlich zwischen den metallischen Bereichen (4), welche zwischen den entsprechenden leitenden Bereichen komprimiert ist, leitet und wobei der Kleber in den Zwischenräumen zwischen den metallischen Bereichen (4) und in den Zwischenräumen zwischen den leitenden Bereichen isolierend bleibt.

7. Verfahren nach einem der Ansprüche 1 und 2, **dadurch gekennzeichnet, dass** die gesamte Rückseite der Zelle (2) auf der komponentenlosen Seite der gedruckten Schaltung (1) fixiert ist.

8. Verfahren nach einem der Ansprüche 1, 2 und 7, **dadurch gekennzeichnet, dass** die Montagemittel des Moduls (12) zwei Löcher in zwei Ohren (17) der gedruckten Schaltung (1) sind, die sich darüber hinaus von der Rückseite der Zelle (2) erstrecken.

9. Verfahren nach einem der Ansprüche 1 und 2, **dadurch gekennzeichnet, dass** die gedruckte Schaltung (1) mittels eines doppelseitigen Klebebands (25) an der Rückseite der Zelle (2) fixiert ist.

10. Verfahren nach einem der Ansprüche 1 und 2, **dadurch gekennzeichnet, dass** ein Rand der gedruckten Schaltung (1) eine metallische Kontaktklemme (10) trägt, die um 90° gebogen und auf die Scheibe der Zelle geklebt ist.

11. Anzeigemodul, insbesondere für eine Armbanduhr, wobei das Modul zumindest eine Flüssigkristallzelle (2) aufweist, die mit einer flexiblen gedruckten Anzeigesteuerschaltung verbunden ist, wobei die gedruckte Schaltung (1) auf einer einzigen Seite elektronische Komponenten (6, 7, 8) zur Steuerung der Zelle (2) und metallische Verbindungsbahnen (5) zu den Komponenten und zur Zelle (2) aufweist, wobei ein Abschnitt der komponentenlosen Seite der gedruckten Schaltung (1) direkt an der Rückseite der Zelle (2) fixiert und positioniert ist, wobei ein Ende der gedruckten Schaltung in Form einer Zunge (3) eine Reihe metallischer Verbindungsbereiche (4) zur Zelle (2) aufweist, die um 180° gebogen und mechanisch und elektrisch mit den entsprechenden leitenden Abschnitten der Zelle (2) verbunden sind, **dadurch gekennzeichnet, dass** die gedruckte Schaltung (1) Montagemittel (12) des Moduls zur Montage des Moduls im Gehäuse eines Geräts aufweist, wobei die Montagemittel dazu vorgesehen sind, die Anzeige der Zelle (2), welche die Kennzeichnungsmittel der Anzeige (13) aufweist, gegenüber den Montagemitteln positioniert wird und wobei ein eine metallische Kontaktklemme (10) aufweisender Rand der flexiblen gedruckten Schaltung (1) in einem gebogenen und geklebten Zustand auf der Scheibe der Zelle (2) ist.

12. Modul nach Anspruch 11, **dadurch gekennzeichnet, dass** die metallischen Bereiche (4) auf der Zunge (3) und die entsprechend leitenden Bereiche der Zelle (2) mittels eines anisotropen leitenden Klebebands miteinander verbunden sind, welches nur zwischen den metallischen Bereichen (4) leitend ist, die gegen die entsprechenden leitenden Bereiche gedrückt sind, wobei der Kleber in den Zwischenräumen zwischen den metallischen Bereichen und in den Zwischenräumen zwischen den leitenden Abschnitten isolierend bleibt.

13. Modul nach Anspruch 11, **dadurch gekennzeichnet, dass** es aus zwei Flüssigkristallzellen (2) gebildet ist, von denen die erste Zelle auf der zweiten Zelle fixiert ist, wobei die flexible gedruckte Schaltung (1) an der Rückseite der zweiten Zelle (2) fixiert ist, wobei die gedruckte Schaltung (1) zwei am selben Ende der gedruckten Schaltung (1) nebeneinander positionierte Zungen (3) aufweist, die jeweils eine Reihe metallischer elektrischer und mechanischer Verbindungsbereiche (4) zu den leitenden Bereichen der entsprechenden Zellen aufweisen, wobei sich die Reihen der leitenden Bereiche nicht überdecken.

14. Modul nach Anspruch 11, **dadurch gekennzeichnet, dass** die gedruckte Schaltung (1) auf die gesamte Rückseite der Zelle (2) geklebt ist, die einen oberen Polarisator (21) und drei Blätter (22, 23, 24) aufweist, von denen das letzte Blatt, auf welches die gedruckte Schaltung geklebt ist, des Typs Reflektor/Polarisator ist.

15. Uhr umfassend ein Anzeigemodul nach einem der Ansprüche 11 bis 14, **dadurch gekennzeichnet, dass** das Gehäuse der Uhr (40) komplementäre Montagemittel (41) aufweist, die mit den Montagemitteln des Moduls (12) zur lateralen Positionierung des Moduls zusammenwirken, um die Anzeige der Flüssigkristallzelle (2) in eine bestimmte Position innerhalb des Gehäuses der Uhr (40) zu bringen.

16. Uhr nach Anspruch 15, **dadurch gekennzeichnet, dass** die komplementären Montagemittel (41) zwei Zapfen sind, die sich bis zum Boden des Gehäuses (40) vertikal erstrecken und mit den Montagemitteln des Moduls (12), welche zwei auf zwei Ohren (17) platzierte Löcher aufweisen, zusammenwirken und sich zu diesem von der Rückseite der Zelle (2) erstrecken.

## Claims

1. Method for manufacturing a display module including at least one liquid crystal cell (2) connected to a display control printed circuit (1), said printed circuit (1) having, arranged on a single face, electronic components (6, 7, 8) for controlling the cell (2) and metal paths (5) for connection to said components and to said cell (2), **characterised in that** the method includes the steps of:
- placing the printed circuit (1) on the back side of the cell (2), the face of the printed circuit (1) with no components facing the back of the cell (2),
- positioning the printed circuit (1) with respect to the cell (2), said printed circuit (1) including means (12) for assembling the module for mounting the module in an apparatus case, said assembling means being provided, so that, during positioning of the printed circuit (1) with respect to display marking means (13) arranged on the cell (2), the display of the cell (2) is positioned with respect to the assembling means, and
- securing a portion of the face of the printed circuit (1) with no components directly to the back of said cell (2).

2. Method for manufacturing a display module including at least one liquid crystal cell (2) connected to a display control printed circuit (1), said printed circuit (1) having, arranged on a single face, electronic components (6, 7, 8) for controlling the cell (2) and metal paths (5) for connection to said components and to said cell (2), **characterised in that** the method includes the steps of:
- placing the printed circuit (1) on the back side of the cell (2), the face of the printed circuit (1) with no components facing the back of said cell (2),
- securing a portion of the face of the printed circuit (1) with no components directly to the back of said cell (2), and
- making means (12) for assembling the module on the printed circuit (1), for mounting the module in an apparatus case, said assembling means being positioned with respect to marking means (13) arranged on the cell (2), so that the display of the cell (2) is positioned with respect to the assembling means.

3. Method according to claims 1 or 2, **characterised in that** the printed circuit (1) is flexible, **in that**, in a preliminary step, metal pads (4) of the printed circuit (1) arranged on one end in the form of a tongue (3) of said printed circuit (1) are connected to corresponding conductive pads of the cell (2) arranged on one of the plates (22) of said cell (2), and **in that** the printed circuit (1) is bent at 180° in the region of the tongue to be placed on the back side of the cell (2).

4. Method according to claims 1 and 2, **characterised in that** the printed circuit (1) is flexible, **in that**, in a final step, one end in the shape of a tongue (3) is bent at 180° and secured so as to connect metal pads (4) of the printed circuit (1) arranged on the tongue (3) to corresponding conductive pads of the cell (2) arranged on one of the plates (22) of said cell (2).

5. Method according to any of claims 3 and 4, **characterised in that** the module is formed of two liquid crystal cells (2) the first cell of which is secured above the second cell, said printed circuit (1) being secured to the back of the second cell (2), and **in that** the printed circuit (1) includes two tongues (3) placed one next to the other on the same end, each carrying a series of metal pads (4) for the electric and mechanical connection of the printed circuit (1) to the conductive pads of the respective cells (2), the two series of conductive pads not covering each other when seen from above.

6. Method according to any of claims 3 to 5, **characterised in that** the metal pads (4) of the printed circuit (1) are connected to the respective conductive pads of the liquid crystal cell or cells (2) by applying a strip of anisotropic conductive adhesive material on the conductive pads or on the metal pads (4), by placing the tongue or tongues facing a respective plate extension (16) carrying said conductive pads so as to align each metal pad (4) in superposition with each corresponding conductive pad, and by compressing and heating the tongue or tongues (3) against the face of the respective plate (22) to establish the electric connection between said metal pads (4) and conductive pads, said adhesive material being conductive solely between the metal (4) pads compressed against the respective conductive pads, the adhesive material remaining insulating in the empty spaces between the metal pads (4) and in the empty spaces between the conductive pads.

7. Method according to claims 1 and 2, **characterised in that** the entire surface of the back of the cell (2) is secured onto the face of the printed circuit (1) with no components.

8. Method according to any of claims 1, 2 and 7, **characterised in that** the module assembly means (12) are two holes made in two lugs (17) of the printed circuit (1) extending beyond the surface of the back of the cell (2).

9. Method according to claims 1 and 2, **characterised in that** the printed circuit (1) is secured to the back of the cell (2) using a strip of adhesive material (25).

10. Method according to claims 1 and 2, **characterised in that** one edge of the printed circuit (1) carrying a metal contact terminal (10) is bent at 90° and adhered to the edge of the cell.

11. Display module, in particular for a wristwatch, said module including at least one liquid crystal cell (2) connected to a flexible display control printed circuit (1), said printed circuit (1) having, arranged on a single face, electronic components (6, 7, 8) for controlling the cell (2) and metal paths (5) for connection to said components and to said cell (2), one portion of the face of the printed circuit (1) with no components being secured and positioned directly on the back of the cell (2), one end of the printed circuit in the form of a tongue (3) carrying a series of metal pads (4) for connection to said cell (2) being bent at 180° and mechanically and electrically connected to respective conductive pads of the cell (2), **characterised in that** the printed circuit (1) includes module assembly means (12) for mounting the module in an apparatus case, said assembling means being provided, so that the display of the cell (2), which includes display marking means (13), is positioned with respect to the assembling means, and **in that** one edge of the flexible printed circuit (1) carrying a metal contact terminal (10) is in a bent state and adhered to the edge of the cell (2).

12. Module according to claim 11, **characterised in that** the metal pads (4) on the tongue (3) and the respective conductive pads of the cell (2) are connected by means of a strip of anisotropic conductive adhesive material which is only conductive between the metal pads (4) compressed against the respective conductive pads, the adhesive material remaining insulating in the empty spaces between the metal pads (4) and in the empty spaces between the conductive pads.

13. Module according to claim 11, **characterised in that** it is formed of two liquid crystal cells (2) the first cell of which is secured above the second cell, the flexible printed circuit (1) being secured to the back of the second cell (2), and **in that** the printed circuit (1) includes two tongues (3) placed one next to the other on the same end of the printed circuit (1), each carrying a series of metal pads (4) for the electric and mechanical connection to the conductive pads of the respective cells, the two series of conductive pads not covering each other when seen from above.

14. Module according to claim 11, **characterised in that** the printed circuit (1) is adhered over the entire surface of the back of the cell (2) which includes a top polariser (21) and three plates (22, 23, 24) the back plate of which, onto which the printed circuit is adhered, is of the reflector/polariser type.

15. Watch including a display module according to one of claims 11 to 14, **characterised in that** the watch case (40) includes complementary assembly means (41) co-operating with the module assembly means (12) for the lateral positioning of said module so that the display of the liquid crystal display (2) is in a determined position in the watch case (40).

16. Watch according to claim 15, **characterised in that** the complementary display means (41) are two studs rising vertically from the back cover of the case (40) co-operating with the module assembly means (12) which include two holes arranged in two lugs (17) extending beyond the surface of the back of the cell (2).
